# EUROPEAN PATENT SPECIFICATION

(11) **EP 1 942 708 B1**
(45) Date of publication and mention of the grant of the patent: **29.07.2009**
(21) Application number: 08100061.4
(22) Date of filing: 03.01.2008
(51) Int. Cl.: H05K 1/02, G02F 1/13

(54) **Flexible circuit board of liquid crystal display having a light absorbing layer**
Flüssigkristallanzeige einer flexiblen Leiterplatte mit lichtabsorbierender Schicht
Affichage à cristaux liquides pour carte de circuit flexible ayant une légère couche d'absorption

(30) Priority: 03.01.2007 KR 20070000790
(43) Date of publication of application: 09.07.2008
(73) Proprietor: Samsung Mobile Display Co., Ltd., Suwon-si Gyeonggi-do (KR)
(72) Inventor: Chung, Jaemo, Gyeonggi-do (KR); Sung, Jinhee, Gyeonggi-do (KR); Kim, Sunghwan, Gyeonggi-do (KR)
(74) Representative: Hengelhaupt, Jürgen

(56) References cited:
- JP-A- 9 274 446
- US-A- 4 439 818
- US-A1- 2005 190 333
- US-A1- 2006 082 297

## Description

### BACKGROUND OF THE INVENTION

### 1. Field of the Invention

Aspects of the present invention relate to a flexible circuit board of a liquid crystal display, and more particularly to a flexible circuit board of a liquid crystal display having a light absorbing layer.

### 2. Description of the Related Art

In general, a liquid crystal display is one of several flat display devices to display an image. The liquid crystal display displays an image by use of a liquid crystal. The liquid crystal display is advantageous in that it is thinner and lighter than other display devices, and that it has low driving voltage and low power consumption. Accordingly, liquid crystal display displays are used widely in industrial applications.

The liquid crystal display includes a thin film transistor (TFT) substrate, a color filter substrate disposed opposite to the thin film transistor substrate, and a liquid crystal display panel composed of a liquid crystal, which is disposed between the thin film transistor substrate and the color filter substrate, and which changes the transmission amount of light as an electrical signal is applied thereto. Additionally, a driving module, which applies an electrical signal to the liquid crystal display panel, is electrically coupled to the liquid crystal display. For this end, a flexible circuit board is disposed between the liquid crystal display panel and the driving module.

Since the liquid crystal that is included in the liquid crystal display panel does not emit light by itself, the liquid crystal display requires a light source that provides light having a predetermined brightness or above to the liquid crystal display panel so as to display an image.

A high-brightness light emitting diode has recently come into use in small display devices such as a cellular phone, a PMP (portable multimedia player) and/or a digital camera as a light source to reduce the thickness and weight thereof. For example, such a light source is electrically coupled to the flexible circuit board, and the light from the light source is transmitted to a light guide plate disposed in the rear surface of the liquid crystal display panel.

The light from the light source that is mounted on the flexible circuit board has to be directed to the light guide plate. However, some of the light is not transmitted to the light guide plate but is transmitted to undesired areas of the flexible circuit board. For example, the flexible circuit board has a conductive pattern formed thereon and passive elements such as resistors or capacitors that are mounted on the flexible circuit board. However, the light from the light source is undesirably transmitted to the conductive pattern and the passive elements.

Since the light from the light source carries energy of a predetermined intensity, the energy affects the conductive pattern and the passive elements, and the conductive pattern and the passive elements malfunction. Therefore, although the structure in which the light source is mounted on the flexible circuit board is a technique that is necessary to meet the recent trend towards slim and lightweight devices, the reliability of the technique when applied to such devices may be reduced by the malfunctions of the various passive elements.

Document US 2006/082297 discloses a light emitting diode array that enables high focused light output.

### SUMMARY OF THE INVENTION

Aspects of the present invention are related to overcoming the foregoing and other problems, and an aspect of the present invention is to provide a liquid crystal display comprising a flexible circuit board having a light absorbing layer so that the light from the light source is not transmitted to the conductive pattern and the passive element, and other benefits.

The above described and/or other aspects, are achieved by a liquid crystal display according to claim 1.

Preferably, the ink layer is formed in a bend of the first insulating film, and the ink layer may be easier to bend than the first insulating film. The ink layer may be a UV curing ink and/or an IR curing ink.

Preferably, the light absorbing layer may include a first light absorbing layer formed on the surface of the first insulating film, and a second light absorbing layer formed on the surface of the second insulating film.

Preferably, a window may be formed in the second light absorbing layer so that the one or more conductive patterns to which the light source is electrically coupled is exposed.

Preferably, a window may be formed in the second light absorbing layer so to expose a portion of the conductive patterns, to which the at least one light source is electrically coupled.

Preferably, the one or more dimensions of the window may be greater than that of the one or more conductive patterns.

Preferably, the surface area of the window is greater than that of the portion of the conductive patterns, to which the at least one light source is electrically coupled.

Preferably, the dimensions of the first light absorbing layer may be greater than that of the second light absorbing layer.

Preferably, at least one passive element electrically coupled to portions of the one or more conductive patterns may be formed on the outer circumference of the second light absorbing layer.

Preferably, the first light absorbing layer may be formed on the first insulating film to correspond to the passive element.

Preferably, the light absorbing layer may include diethylene glycol monoethyl ether acetate, titanium dioxide and/or epoxy resin.

Preferably, the light source may be a light emitting diode.

The first insulating film includes a first region in which the light source and the light absorbing layers are formed, a second region which is formed on (or to) one side of the first region and electrically coupled to the liquid crystal display panel, and a third region which is formed on (or to) one side of the second region and electrically coupled to an external controller.

Preferably, first cutout portions are symmetrically formed in the second region spaced apart from each other and a second cutout portion is formed between the first cutout portions. A panel connector electrically coupled to the liquid crystal panel may be formed in the cutout region that includes the first and second cutout portions.

Preferably, the one or more conductive patterns of the panel connection unit may be exposed through the first insulating film.

Preferably, a controller connector electrically coupled to the external controller may be formed in the third region.

Preferably, the one or more conductive patterns of the controller connector may be exposed through the first insulating film.

Preferably, in the first and third regions, fixing holes may be formed at the respective corresponding positions.

The flexible circuit board of a liquid crystal display according to aspects of the present invention minimizes the effect of the light from the light source that is directed to the one or more conductive patterns and the passive element by having the first and second light absorbing layers be formed on the outer circumference of the light source. Therefore, an aspect of the present invention prevents or reduces the malfunction of the passive element as well as the malfunction of the liquid crystal panel, effectively.

The flexible circuit board of a liquid crystal display according to an aspect of the present invention has the light source and passive element formed in the first region, and the panel connector electrically coupled to the liquid crystal display panel formed in the second region, and the controller connector connected to the external controller formed in the third region. Accordingly, it is possible to electrically connect a large number of parts to each other in a minimum of an area efficiently. Accordingly, a flexible circuit board according to aspects of the present invention can be readily applicable to slim and lightweight portable displays.

The flexible circuit board of a liquid crystal display including the light absorbing layers according to an aspect of the present invention prevents or reduces the light from the light source from being transmitted to undesired areas (for example, the area in which a driver IC (integrated circuit) to drive the liquid crystal panel is positioned). Accordingly, the image quality of the liquid crystal display is improved.

According to the flexible circuit board of a liquid crystal display according to an aspect of the present invention, the first, second and third regions include the first insulating film and second Insulating film. Therefore, it is easy to fold the desired region, and easy to apply the flexible circuit board to the portable display device that may need a multitude of bends therein.

The flexible circuit board of a liquid crystal display according to an aspect of the present invention may resist the weakening in the circuit component mounting strength due to the bending of the circuit board by having the ink layer instead of the first insulating film formed in the second region.

According to an aspect of the present invention, a flexible circuit board of a liquid crystal display includes a first insulating film, one or more conductive patterns formed on the first insulating film, a second insulating film formed on the first insulating film and covering the one or more conductive patterns, at least one light source which is electrically coupled to the one or more conductive patterns, one or more light absorbing layers formed on the outer circumference of the at least one light source to absorb light from the light source, and an ink layer formed over the second insulating film and the one or more conductive patterns at a portion of the flexible circuit board that lacks the first insulating film.

Additional aspects and/or advantages of the invention will be set forth in part in the description which follows and, in part, will be obvious from the description, or may be learned by practice of the invention.

### BRIEF DESCRIPTION OF THE DRAWINGS

These and/or other aspects and advantages of the invention will become apparent and more readily appreciated from the following description of the aspects, taken in conjunction with the accompanying drawings of which:
FIGS. 1A, 1B, and 1C are a top plan view, a side elevational view, and a bottom plan view, respectively, illustrating a flexible circuit board of a liquid crystal display having a light absorbing layer.
FIG. 2 is a top plan view illustrating a flexible circuit board of a liquid crystal display having a light absorbing layer before mounting a light source.
FIG. 3 is a cross-sectional view of line 3-3 of FIG. 1.
FIG. 4 is a cross-sectional view of line 4-4 of FIG. 1.
FIG. 5 is a cross-sectional view of line 5-5 of FIG. 1.
FIG. 6 is a cross-sectional view of line 6-6 of FIG. 1.
FIG. 7 is a cross-sectional view of line 7-7 of FIG. 1.

### DETAILED DESCRIPTION OF THE EMBODIMENTS

Reference will now be made in detail to the various aspects of the present invention, examples of which are illustrated in the accompanying drawings, wherein like reference numerals refer to the like elements throughout. The aspects are described below in order to explain the present invention by referring to the figures.

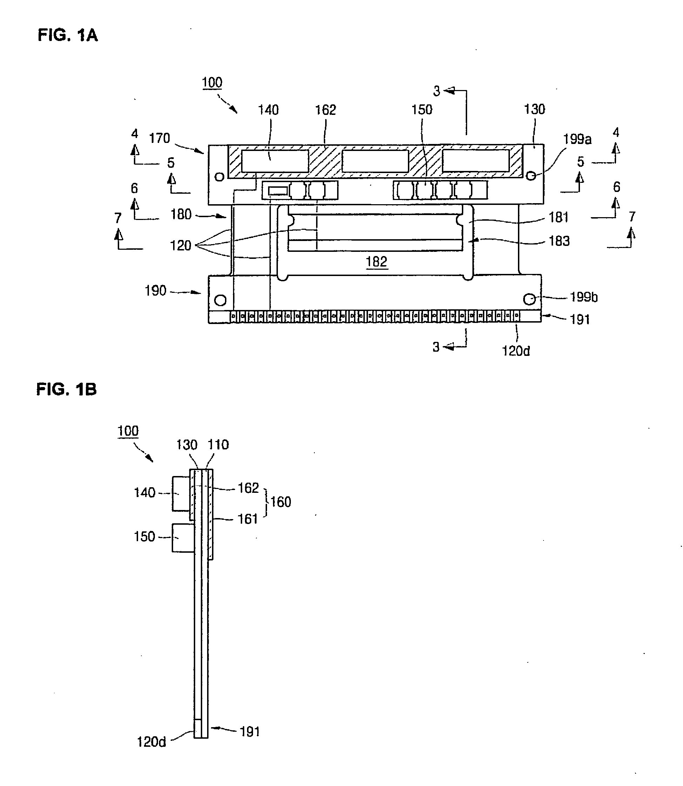

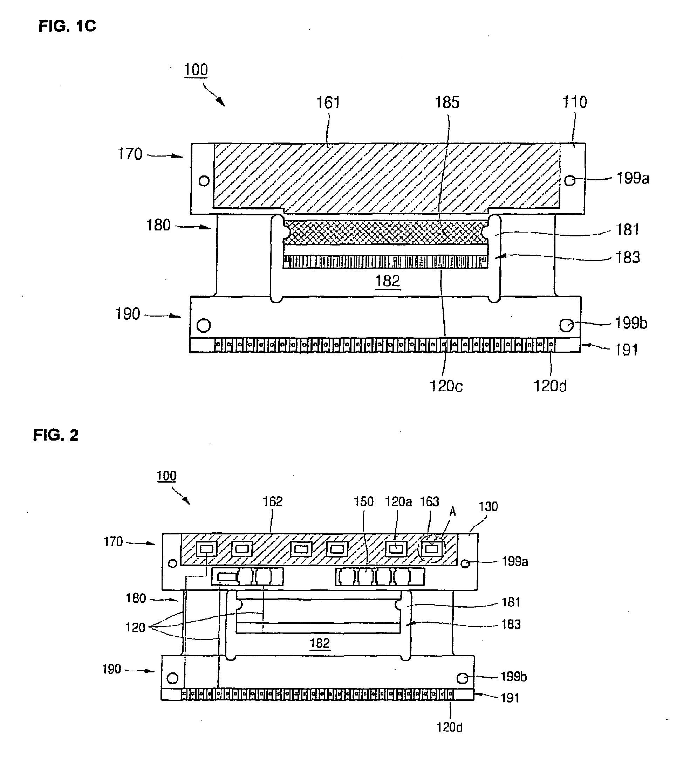

Referring to FIGS. 1A, 1B, and 1C, a top plan view, a side elevational view, and a bottom plan view of a flexible circuit board of a liquid crystal display having a light absorbing layer according to aspects of the present invention are illustrated, respectively. Referring to FIG. 2, a flexible circuit board of a liquid crystal display having a light absorbing layer before mounting a light source is illustrated in the top plan view.

As shown in FIGS. 1A, 1B, 1C, and FIG. 2, a flexible circuit board 100 includes a first insulating film 110, a conductive pattern 120, a second insulating film 130, a light source 140, a passive element 150, and a light absorbing layer 160.

In the non-limiting aspect shown, the first insulating film 110 is a base layer, and may be formed with any one selected from flexible polyimide and the equivalent thereof, but the material is not restricted thereto.

In the non-limiting aspect shown, the conductive pattern or patterns 120 are formed on the first insulating film 110. The conductive pattern 120 may be formed with any one selected from a high conductive copper thin film and the equivalent thereof, but the material is not restricted thereto. The conductive pattern 120 provides power and electrical signals to all sorts of electronic components that may be electrically coupled to the flexible circuit board 100. For example, the conductive pattern 120 provides power to the light source 140 or provides an electrical signal to the passive element 150. Only some of conductive patterns 120 are illustrated in FIGS. 1A and 2, however, several tens to thousands of these conductive patterns 120 may be formed. In the aspect shown, the conductive patterns 120 are not readily visible because the second insulating film 130 is almost opaque.

In the non-limiting aspect shown, the second insulating film 130 is formed on the first insulating film 110 and covers the conductive pattern 120. Therefore, the second insulating film 130 prevents the conductive pattern 120 from being exposed to the outside and being damaged. The second insulating film 130 is not formed on parts of the conductive pattern 120 to which the light source 140 and the passive element 150 are to be electrically coupled. The second insulating film 130 may be any one selected from a flexible cover film and the equivalent thereof, but the material is not restricted thereto.

In the non-limiting aspect shown, the light source 140 may be electrically coupled to the conductive pattern 120. Substantially, a conductive pad 120a is formed on the conductive pattern 120, and the conductive pad 120a is exposed to the outside of (or exposed through) the second insulating film 130. Therefore, the light source 140 may be electrically coupled to the conductive pad 120a by soldering and/or similar or other attaching or bonding technique. The light source 140 may be any one selected from the high-brightness light emitting diode and the equivalent thereof, but the device is not restricted thereto. Three light sources 140 arranged in a row are illustrated in the drawing. However, the number of the light source 140 is not restricted thereto.

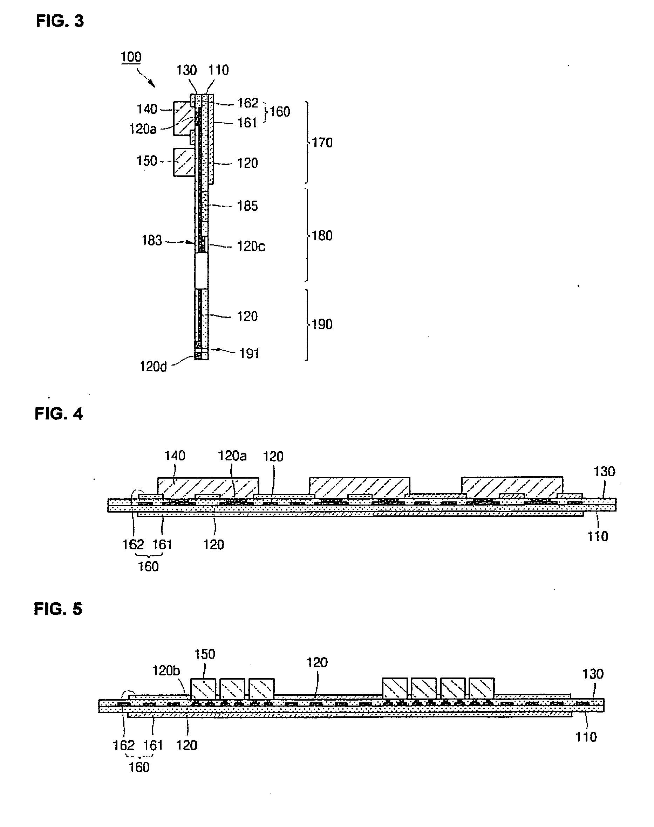

In the non-limiting aspect shown, the passive element 150 may be also electrically coupled to the conductive pattern 120. Specifically, a conductive pad 120b (shown in FIG. 5) is formed on the conductive pattern 120, and the conductive pad 120b is exposed to the outside of (or exposed through) the second insulating film 130. Therefore, the passive element 150 may be electrically coupled to the conductive pad 120b by soldering and/or similar or other attaching or bonding technique. In the non-limiting aspect shown, the passive element 150 may be a resistor, a capacitor and/or an inductor or other similar or other passive elements. Accordingly, the kind of the passive element 150 is not restricted thereto. As shown, seven of the passive elements 150 are arranged in a row as illustrated in the drawing. However, the number of the passive elements 150 is not restricted thereto.

In the non-limiting aspect shown, the light absorbing layer 160 includes a first light absorbing layer 161 formed on the first insulating film 110, and a second light absorbing layer 162 formed on the second insulating film 130. The first light absorbing layer 161 is formed on the first insulating film 110 which is opposite to the surface on which the light source 140 and the passive element 150 are formed. The second light absorbing layer 162 is formed on the second insulating film 130 corresponding to a peripheral portion of (or an area adjacent) the light source 140. The second light absorbing layer 162 is spaced apart from the conductive pad 120a so that the light source 140 is electrically coupled to the conductive pad 120a with ease. That is, a window 163 is formed in the second light absorbing layer 162, and the conductive pad 120a is exposed to the outside through the window 163. The size of the window 163 is slightly greater than that of the conductive pad 120a. Therefore, the light from the light source 140 is hardly (or not readily) transmitted to the conductive pattern 120 and the passive element 150 due to the second light absorbing layer 162. That is, the light from the light source 140 is transmitted only to a light guide plate, which is not depicted in the drawings, and the light is not transmitted to the conductive pattern 120 and the passive element 150. Thus, a flow of light into the conductive pattern and the passive elements of the inventive flexible circuit board of a liquid crystal display is prevented by the first light absorbing layer together or in conjunction with the second light absorbing layer. That is, the first light absorbing layer is provided such that it absorbs light which flows into windows formed within the second light absorbing layer or the outside or circumference of the second light absorbing layer. The light absorbing layer 160 may be one selected from a compound consisting of diethylene glycol monoethyl ether acetate (DCAC) (C₈H₁₆O₄), titanium dioxide (TiO₂) and/or epoxy resin and the equivalent thereof. However, the material of the light absorbing layer 160 is not restricted thereto. The light absorbing layer 160 having the above described structure is referred to as black silk due to the black color. Further, the light absorbing layer 160 absorbs the light from the light source 140 more efficiently, since the light absorbing layer 160 is black. Furthermore, the light absorbing layer 160 may be formed by any one method selected from screen printing, photo-lithography and the equivalent thereof. However, the formation method thereof is not restricted thereto. The light absorbing layer 160 may be formed by electroless plating and/or electroplating, and it may be formed by coating a black polymer resin, or any combinations thereof.

The flexible circuit board 100 of the liquid crystal display may be divided into a first region 170, a second region 180 and a third region 190 as shown in FIG. 2, for example. Specifically, the first insulating film 110 is divided into the first region 170, the second region 180, and the third region 190.

In the non-limiting aspect shown, the first region 170 is the region in which the light source 140, the passive element 150, and the light absorbing layer 160 are formed. As shown, the first light absorbing layer 161 of the light absorbing layer 160 may be formed in the entire area of the first insulating film 110 corresponding to the first region 170. The second light absorbing layer 162 of the light absorbing layer 160 may be partially formed in the area of the second insulating film 130. That is, the second light absorbing layer 162 is only formed on a portion of the second insulating film 130 comprising the light source 140 and is not formed on a portion of the second insulating film 130 comprising the passive element 150. Therefore, the size of the first light absorbing layer 161 is larger than that of the second light absorbing layer 162.

The second region 180 is adjacent to the first region 170, and a panel connector 183 is formed in the second region 180 so that the liquid crystal panel is electrically coupled thereto. For this end, first cutout portions 181 that are spaced apart at a predetermined distance are formed in the second region 180, and a second cutout portion 182 is formed between the first cutout portions 181 and connects the first cutout portions 181. Therefore, the first cutout portions 181 and the second cutout portion 182 are formed in an "H." shape (or a block U shape). The panel connector 183 that is electrically coupled to the liquid crystal display panel is formed in the cutout region that includes the first cutout portions 181 and the second cutout portion 182. A plurality of conductive patterns 120c (shown in FIG. 1C) are exposed to the outside through the first insulating film 110. In FIG. 1C, the reference numeral 185 is an ink layer which is more flexible than the first insulating layer so as to allow the second region 180 to bend or fold with ease. Further, it is preferable, but not required that the ink layer 185 is selected from UV (ultraviolet) curing ink and/or IR (infrared) curing ink. However, the material or the kind of the ink layer 185 is not restricted thereto. The ink layer 185 is more flexible than the first insulating layer. Accordingly, it is possible to form a structure that bends more easily and is more resistant to a weakening in a circuit component mounting strength due to the bending of the flexible circuit board 100. In the non-limiting aspect shown, the ink layer 185 is formed in a portion of the flexible circuit board 100 that lacks the first insulating film 110. Also, in the non-limiting aspect shown, the ink layer 185 is formed in the region 180 between the first cutout portions 181, where various layers are lacking.

In the non-limiting aspect shown, the third region 190 is adjacent to a side of the second region 180 opposed to the first region (170), and a controller connector 191 is formed in the third region 190 so as to connect an external controller (not shown) electrically thereto. As shown, a plurality of conductive patterns 120d is exposed to the outside via the first insulating film 110 and the second insulating film 130. Additionally, Fixing holes 199a, 199b may be further formed at the respective corresponding position of the first region 170 and the third region 190. These fixing holes 199a, 199b fix the flexible circuit board 100 in a molding frame (not shown) as the flexible circuit board 100 is connected to a fixing protrusion (not shown) of the molding frame.

Referring FIG. 3, a cross-sectional view of line 3-3 of FIG. 1A is described therein. As shown in FIG. 3, the flexible circuit board 100 may be divided into the first region 170, the second region 180 and the third region 190.

In the first region 170, the light source 140 is electrically coupled to the conductive pad 120a formed on the conductive pattern 120. The passive element 150 is electrically coupled to the conductive pad 120b formed on the conductive pattern 120. In the first region 170, the first light absorbing layer 161 is formed on the surface of the first insulating film 110. In the first region 170, the second light absorbing layer 162 is formed on the surface of the second insulating film 130. Here, the second light absorbing layer 162 has the window 163 formed at the periphery of the conductive pad 120a so that the light source 140 is electrically coupled to the conductive pad 120a without hindrance. By way of this structure, the light from the light source 140 is not transmitted to the conductive pattern 120, and the passive element 150 via the conductive pattern 120. Also, the second light absorbing layer 162 is not formed in the region corresponding to the passive element 150.

The panel connector 183 is formed in the second region 180, and the conductive pad 120c formed on the conductive pattern 120 is exposed to the outside. The ink layer 185, which is more flexible than the first insulating layer, is formed in the second region 180 so that the bending (or folding) thereof is executed with ease. The ink layer 185 is selected from a UV (ultraviolet) curing ink and/or an IR (infrared) curing ink, but the kind of the ink layer is not restricted thereto.

The controller connector 191 is formed in the third region. In the controller connector 191, the conductive pad 120d formed on the conductive pattern 120 is exposed to the outside.

Referring to FIG. 4, a cross-sectional view of line 4-4 of FIG. 1A is depicted therein. As shown in FIG. 4, the light source 140, such as the high-brightness light emitting diode, is mounted at a predetermined interval on the flexible circuit board 100. The respective light source 140 is supplied with power via the conductive pad 120a and the conductive pattern 120. The respective light source 140 is electrically coupled to the conductive pad 120a formed on the conductive pattern 120 by soldering, or other methods. The light from the light source 140 is hardly transmitted to the conductive pattern 120 since the first light absorbing layer 161 is formed on the surface of the first insulating film 110 and the second light absorbing layer 162 is formed on the surface of the second insulating film 130.

Referring to FIG. 5, a cross-sectional view of line 5-5 of FIG. 1A is depicted therein.

As shown in the drawing, the passive element or elements 150, such as resistors, capacitors, and/or inductors, are mounted at a predetermined interval on the flexible circuit board 100. The respective passive element 150 is supplied with electrical signals through the conductive pad 120b and the conductive pattern 120. The respective passive element 150 is electrically coupled to the conductive pad 120b formed on the conductive pattern 120 by soldering or other methods.

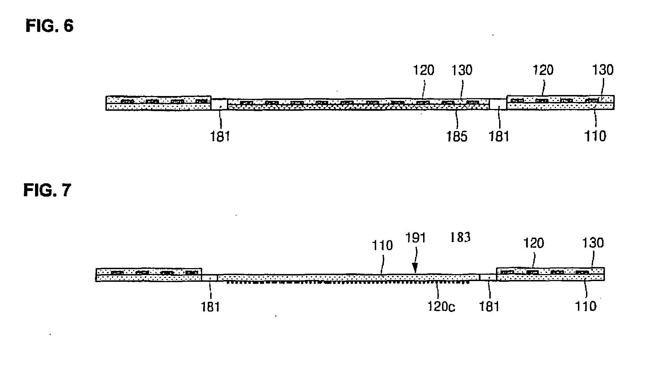

Referring to FIG. 6, a cross-sectional view of line 6-6 of FIG. 1A is depicted therein.

As shown in FIG. 6, in the second region 180, the ink layer 185, instead of the first insulating film 110, is formed on the flexible circuit board 100. That is, the ink layer 185 is adhered to the second insulating film 130 instead of the first insulating film 110. Accordingly, it is possible to bend (or fold) the second region 180. That is, when the panel connector 183 of the second region 180 is bent at a specific angle (or folded) so as to be electrically coupled to the liquid crystal display panel, the bend or the fold in the second region 180 may be damaged by the stress if the ink layer 185 is lacking. Therefore, by forming the ink layer 185 instead of the first insulating film 110 in the second region 180 to be bent, the bend region (or the fold region) absorbs the stress during the bending process and is prevented from being broken.

Referring to FIG. 7, a cross-sectional view of line 7-7 of FIG. 1A is depicted therein. As shown in FIG. 7, the panel connector 183 to which the liquid crystal display panel of the second region 180 is electrically coupled is further formed on the flexible circuit board 100. The panel connector 183 may be a plurality of conductive patterns 120c which is substantially exposed to the outside of (or through) the first insulating substrate 110. That is, all sorts of electrical signals are supplied to the liquid crystal display panel via the controller connector 191, as a plurality of conductive patterns 120c are electrically coupled to the liquid crystal display panel.

In various aspects, the flexible circuit board is applicable to small display devices such as a cellular phone, a PMP (portable multimedia player), a digital camera, and/or similar devices.

As described above, the flexible circuit board of a liquid crystal display according to aspects of the present invention minimizes a phenomenon of light from the light source being directed to the conductive pattern and the passive element by having the first and second light absorbing layers formed on a peripheral portion of the light source. Therefore, aspects of the present invention effectively prevent or reduce the malfunction of the passive element as well as the malfunction of the liquid crystal panel.

The flexible circuit board of a liquid crystal display having a light absorbing layer according to aspects of the present invention prevents or reduces the light from the light source from being directed to the undesired area (for example, the area in which a driver IC (integrated circuit) to drive the liquid crystal panel is positioned). Accordingly, the image quality of the liquid crystal display is improved.

The flexible circuit board of a liquid crystal display according to an aspect of the present invention has the light source and passive element formed in the first region, and has the panel connector electrically coupled to the liquid crystal display panel formed in the second region, and has the controller connector connected to the external controller formed in the third region. Accordingly, it is possible to electrically connect a large number of parts to each other in a minimum of an area efficiently. Accordingly, the flexible circuit board according to an aspect of the present invention can be readily applicable to slim and lightweight portable displays.

According to an aspect of the invention a flow of light into the conductive pattern and the passive elements of the inventive flexible circuit board of a liquid crystal display is prevented by a first light absorbing layer together or in conjunction with a second light absorbing layer. That is, the first light absorbing layer is provided such that it absorbs light which flows into the windows formed within the second light absorbing layer or the outside or circumference of the second light absorbing layer.

The flexible circuit board of a liquid crystal display according to aspects of the present invention may reduce or resist the weakening of the circuit component mounting strength due to the bending of the circuit board by having the ink layer instead of the first insulating film formed in the second region.

Although a few aspects of the present invention have been shown and described, it would be appreciated by those skilled in the art that changes may be made in the aspects without departing from the principles of the invention, the scope of which is defined in the claims and their equivalents.

## Claims

1. A liquid crystal display comprising:
a flexible circuit board and an external controller;
wherein the flexible circuit board comprises:
a first insulating film (110) comprising an ink layer (185);
a plurality of conductive patterns (120) formed on the first insulating film (110);
a second insulating film (130) formed on the first insulating film (110) and covering the conductive patterns (120);
at least one light source (140) which is electrically coupled to the conductive patterns (120); a second light absorbing layer (162) formed on a surface of the second
insulating film (130) in a peripheral portion of the at least one light source (140) for absorbing light from the light source (140), and
wherein the first insulating film (110) includes:
a first region (170) in which the at least one light source (140) and the light absorbing layers (161, 162) are formed;
a second region (180) adjacent to the first region (170) and being electrically coupled to a liquid crystal display panel; and
a third region (190) adjacent to one side of the second region (180) opposed to the first region (170) and being electrically coupled to the external controller.

2. The liquid crystal display as claimed in claim 1, wherein the ink layer (185) replaces a portion of the first insulating film (110).

3. The flexible circuit board for a liquid crystal display as claimed in one of the preceding claims, wherein the ink layer (185) is more flexible than the first insulating film (110).

4. The liquid crystal display as claimed in one of the preceding claims, wherein the ink layer (185) is a UV curing ink and/or an IR curing ink.

5. The liquid crystal display as claimed in one of the preceding claims, further comprising a first light absorbing layer (161) formed on a surface of the first insulating film (110).

6. The liquid crystal display as claimed in claim 5, wherein a surface area of the first light absorbing layer (161) is larger than a surface area of the second light absorbing layer (162).

7. The liquid crystal display as claimed in one of the preceding claims, further comprising at least one passive element (150) which is electrically coupled to a portion (120b) of the conductive patterns (120) and is formed on the second insulating film (130) adjacent to the second light absorbing layer (162).

8. The liquid crystal display as claimed in claim 7, wherein the first light absorbing layer (161) is formed on a portion of the first insulating film (110) corresponding to the at least one passive element (150).

9. The liquid crystal display as claimed in one of the preceding claims, wherein the first and/or the second light absorbing layers (161, 162) include diethylene glycol monoethyl ether acetate, titanium dioxide, epoxy resin, or any combinations thereof.

10. The liquid crystal display as claimed in one of the preceding claims, wherein the at least one light source (140) is a light emitting diode.

11. The liquid crystal display as claimed in one of the preceding claims,
the flexible circuit board further comprising:
a cutout region including first cutout portions (181) and a second cutout portion (182); and
a panel connector (183),
wherein the first cutout portions (181) are spaced apart from each other and are symmetrically formed in the second region (180), and the second cutout portion (182) is formed between the first cutout portions (181), and the panel connector (183) is formed in the cutout region and is electrically coupled to the liquid crystal panel.

12. The liquid crystal display as claimed in claim 11, wherein the panel connector (183) includes portions (120c) of the conductive patterns (120) that are exposed through the first insulating film (110).

13. The liquid crystal display as claimed in one of the preceding claims, wherein the third region (190) includes a controller connector (191) adapted to be electrically coupled to the external controller.

14. The liquid crystal display as claimed in claim 13, wherein the controller connector (191) includes portions (120d) of the conductive patterns (120) that are exposed through the first insulating film (110).

15. The flexible circuit board of a liquid crystal display as claimed in claim 11, further comprising fixing holes formed at respective corresponding positions in the first and third regions.

## Patentansprüche

1. Flüssigkristallanzeige, aufweisend:
eine flexible Leiterplatte und eine externe Steuervorrichtung;
wobei die flexible Leiterplatte aufweist:
einen ersten Isolierfilm (110), der eine Tintenschicht (185) aufweist;
eine Vielzahl von leitfähigen Mustern (120), die auf dem ersten Isolierfilm (110) ausgebildet sind;
einen zweiten Isolierfilm (130), der auf dem ersten Isolierfilm (110) ausgebildet ist und die leitfähigen Muster (120) bedeckt;
zumindest eine Lichtquelle (140), die mit den leitfähigen Mustern (120) elektrisch gekoppelt ist; eine zweite lichtabsorbierende Schicht (162), die zur Absorption von Licht von der Lichtquelle (140) auf einer Oberfläche des zweiten Isolierfilms (130) in einem peripheren Bereich der zumindest einen Lichtquelle (140) ausgebildet ist, und
wobei der erste Isolierfilm (110) aufweist:
eine erste Region (170), in der die zumindest eine Lichtquelle (140) und die lichtabsorbierenden Schichten (161, 162) ausgebildet sind;
eine zur ersten Region (170) benachbarte zweite Region (180), die mit einer Flüssigkristallanzeigetafel elektrisch gekoppelt ist; und
eine dritte Region (190), die zu einer Seite der zweiten Region (180), welche der ersten Region (170) gegenüberliegt, benachbart ist und mit der externen Steuervorrichtung elektrisch gekoppelt ist.

2. Flüssigkristallanzeige nach Anspruch 1, wobei die Tintenschicht (185) einen Abschnitt des ersten Isolierfilms (110) ersetzt.

3. Flexible Leiterplatte für eine Flüssigkristallanzeige nach einem der vorhergehenden Ansprüche, wobei die Tintenschicht (185) flexibler als der erste Isolierfilm (110) ist.

4. Flüssigkristallanzeige nach einem der vorhergehenden Ansprüche, wobei die Tintenschicht (185) eine UV-härtende Tinte und/oder eine IR-härtende Tinte ist.

5. Flüssigkristallanzeige nach einem der vorhergehenden Ansprüche, weiterhin aufweisend eine erste lichtabsorbierende Schicht (161), die auf einer Oberfläche des ersten Isolierfilms (110) ausgebildet ist.

6. Flüssigkristallanzeige nach Anspruch 5, wobei ein Oberflächenbereich der ersten lichtabsorbierenden Schicht (161) größer als ein Oberflächenbereich der zweiten lichtabsorbierenden Schicht (162) ist.

7. Flüssigkristallanzeige nach einem der vorhergehenden Ansprüche, weiterhin aufweisend zumindest ein passives Element (150), das mit einem Abschnitt (120b) der leitfähigen Muster (120) elektrisch gekoppelt ist und auf dem zweiten Isolierfilm (130) benachbart zur zweiten lichtabsorbierenden Schicht (162) ausgebildet ist.

8. Flüssigkristallanzeige nach Anspruch 7, wobei die erste lichtabsorbierende Schicht (161) auf einem Abschnitt des ersten Isolierfilms (110), der dem zumindest einen passiven Element (150) entspricht, ausgebildet ist.

9. Flüssigkristallanzeige nach einem der vorhergehenden Ansprüche, wobei die erste lichtabsorbierende Schicht (161) und/oder die zweite lichtabsorbierende Schicht (162) Diethylenglycol-Monoethyl-Ether-Acetat, Titandioxid, Epoxidharz oder eine Kombination derselben aufweisen/aufweist.

10. Flüssigkristallanzeige nach einem der vorhergehenden Ansprüche, wobei die zumindest eine Lichtquelle (140) eine lichtemittierende Diode ist.

11. Flüssigkristallanzeige nach einem der vorhergehenden Ansprüche,
wobei die flexible Leiterplatte weiterhin aufweist:
eine Aussparungsregion, die erste Aussparungsbereiche (181) und einen zweiten Aussparungsbereich (182) aufweist; und
ein Tafelverbindungselement (183);
wobei die ersten Aussparungsbereiche (181) voneinander beabstandet sind und in der zweiten Region (180) symmetrisch ausgebildet sind, und wobei der zweite Aussparungsbereich (182) zwischen den ersten Aussparungsbereichen (181) ausgebildet ist, und wobei das Tafelverbindungselement (183) in der Aussparungsregion ausgebildet ist und mit der Flüssigkristallanzeigetafel elektrisch gekoppelt ist.

12. Flüssigkristallanzeige nach Anspruch 11, wobei das Tafelverbindungselement (183) Abschnitte (120c) der leitfähigen Muster (120) aufweist, die durch den ersten Isolierfilm (110) hindurch freigelegt sind.

13. Flüssigkristallanzeige nach einem der vorhergehenden Ansprüche, wobei die dritte Region (190) ein Steuervorrichtungs-Verbindungselement (191) aufweist, das zur elektrischen Kopplung mit der externen Steuervorrichtung ausgebildet ist.

14. Flüssigkristallanzeige nach Anspruch 13, wobei das Steuervorrichtungs-Verbindungselement (191) Abschnitte (120d) der leitfähigen Muster (120) aufweist, die durch den ersten Isolierfilm (110) hindurch freigelegt sind.

15. Flexible Leiterplatte einer Flüssigkristallanzeige nach Anspruch 11, weiterhin aufweisend Befestigungslöcher, die an einander jeweils entsprechenden Positionen in der ersten und dritten Region ausgebildet sind.

## Revendications

1. Dispositif d'affichage à cristaux liquides comportant :
une plaquette à circuit souple et une unité de commande extérieure ;
dans lequel la plaquette à circuit souple comporte :
un premier film isolant (110) comportant une couche d'encre (185) ;
de multiples motifs conducteurs (120) formés sur le premier film isolant (110) ;
un second film isolant (130) formé sur le premier film isolant (110) et recouvrant les motifs conducteurs (120) ;
au moins une source de lumière (140) qui est couplée électriquement aux motifs conducteurs (120) ;
une seconde couche (162) d'absorption de lumière formée sur une surface du second film isolant (130) dans une partie périphérique de la, au moins une, source de lumière (140) pour absorber de la lumière provenant de la source de lumière (140), et
dans lequel le premier film isolant (110) comprend :
une première région (170) dans laquelle la, au moins une, source de lumière (140) et les couches (161, 162) d'absorption de lumière sont formées ;
une deuxième région (180) adjacente à la première région (170) et couplée électriquement à un panneau d'affichage à cristaux liquides ; et
une troisième région (190) adjacente à un côté de la deuxième région (180) opposé à la première région (170) et couplée électriquement à l'unité de commande extérieure.

2. Dispositif d'affichage à cristaux liquides selon la revendication 1, dans lequel la couche d'encre (185) remplace une partie du premier film isolant (110).

3. Plaquette à circuit souple pour un dispositif d'affichage à cristaux liquides selon l'une des revendications précédentes, dans laquelle la couche d'encre (185) est plus souple que le premier film isolant (110).

4. Dispositif d'affichage à cristaux liquides selon l'une des revendications précédentes, dans lequel la couche d'encre (185) est constituée d'une encre durcissant par UV et/ou d'une encre durcissant par IR.

5. Dispositif d'affichage à cristaux liquides selon l'une des revendications précédentes, comportant en outre une première couche (161) d'absorption de lumière formée sur une surface du premier film isolant (110).

6. Dispositif d'affichage à cristaux liquides selon la revendication 5, dans lequel une étendue de surface de la première couche (161) d'absorption de lumière est plus grande qu'une étendue de surface de la seconde couche (162) d'absorption de lumière.

7. Dispositif d'affichage à cristaux liquides selon l'une des revendications précédentes, comportant en outre au moins un élément passif (150) qui est couplé électriquement à une partie (120b) des motifs conducteurs (120) et est formé sur le second film isolant (130) à proximité immédiate de la seconde couche (162) d'absorption de lumière.

8. Dispositif d'affichage à cristaux liquides selon la revendication 7, dans lequel la première couche (161) d'absorption de lumière est formée sur une partie du premier film isolant (110) correspondant au, au moins un, élément passif (150).

9. Dispositif d'affichage à cristaux liquides selon l'une des revendications précédentes, dans lequel la première et/ou la seconde couche (161, 162) d'absorption de lumière comprennent de l'acétate d'éther monoéthylique de diéthylèneglycol, du dioxyde de titane, une résine époxy ou une combinaison quelconque de ceux-ci.

10. Dispositif d'affichage à cristaux liquides selon l'une des revendications précédentes, dans lequel la, au moins une, source de lumière (140) est une diode à émission de lumière.

11. Dispositif d'affichage à cristaux liquides selon l'une des revendications précédentes,
la plaquette à circuit souple comportant en outre :
une région découpée comprenant des premières parties découpées (181) et une seconde partie découpée (182) ; et
un connecteur (183) de panneau,
dans lequel les premières parties découpées (181) sont espacées l'une de l'autre et sont formées symétriquement dans la deuxième région (180), et la seconde partie découpée (182) est formée entre les premières parties découpées (181), et le connecteur de panneau (183) est formé dans la région découpée et est couplé électriquement au panneau à cristaux liquides.

12. Dispositif d'affichage à cristaux liquides selon la revendication 11, dans lequel le connecteur (183) de panneau comprend des parties (120c) des motifs conducteurs (120) qui sont à découvert à travers le premier film isolant (110).

13. Dispositif d'affichage à cristaux liquides selon l'une des revendications précédentes, dans lequel la troisième région (190) comprend un connecteur (191) d'unité de commande conçu pour être couplé électriquement à l'unité de commande extérieure.

14. Dispositif d'affichage à cristaux liquides selon la revendication 13, dans lequel le connecteur (191) d'unité de commande comprend des parties (120d) des motifs conducteurs (120) qui sont à découvert à travers le premier film isolant (110).

15. Plaquette à circuit souple d'un dispositif d'affichage à cristaux liquides selon la revendication 11, comportant en outre des trous de fixation formés dans des positions correspondantes respectives dans les première et troisième régions.
